# EUROPEAN PATENT SPECIFICATION

(11) **EP 1 970 972 B1**
(45) Date of publication and mention of the grant of the patent: **07.09.2011**
(21) Application number: 07021184.2
(22) Date of filing: 30.10.2007
(51) Int. Cl.: H01L 35/22, H01L 35/34, F02G 5/02

(54) **Manufacturing method of thermoelectric converter**
Herstellungsverfahren für einen thermoelektrischen Wandler
Procédé de fabrication d'un convertisseur thermoélectrique

(30) Priority: 15.03.2007 WO PCT/JP2007/055260
(43) Date of publication of application: 17.09.2008
(73) Proprietor: IBIDEN CO., LTD., Ogaki-shi Gifu 503-8604 (JP)
(72) Inventor: Ohno, Kazushige, Ibi-gun, Gifu 501-0695 (JP)
(74) Representative: HOFFMANN EITLE

(56) References cited:
- EP-A- 0 773 592
- EP-A- 1 030 379
- JP-A- 2002 076 541
- JP-A- 2003 332 644
- JP-A- 2006 339 284
- US-A- 5 952 728
- US-A- 6 127 619

## Description

### BACKGROUND OF THE INVENTION

### 1. Field of the Invention

The present invention relates to manufacturing methods of thermoelectric converters.

### 2. Description of the Related Art

When one end of a p-type semiconductor and one end of an n-type semiconductor are joined through an electrode, and this junction is set at high temperature while the other end of each of the p-type semiconductor and the n-type semiconductor is set at low temperature, an electromotive force is generated between the ends of each of the p-type semiconductor and the n-type semiconductor in accordance with the difference in temperature between the high temperature part and the low temperature part.

The electromotive force generated between the ends of each of the p-type semiconductor and the n-type semiconductor is referred to as a thermoelectromotive force, and such an effect is referred to as the Seebeck effect. On the other hand, when one end of a p-type semiconductor and one end of an n-type semiconductor are joined through an electrode, and a current is caused to flow from the other ends of the p-type semiconductor and the n-type semiconductor, a difference in temperature is caused between the ends of each semiconductor. This phenomenon is referred to as the Peltier effect.

Elements having these effects are collectively referred to as thermoelectric conversion elements. With respect to the Seebeck effect, the direction of current is reversed by switching the junction of the thermoelectric conversion element between high temperature and low temperature. Further, it is known that a greater electromotive force is obtained with a greater difference in temperature.

The electromotive force of each single thermoelectric conversion element is not so great. However, a thermoelectric conversion module into which a large number of such thermoelectric conversion elements are combined performs as a static thermoelectric converter characterized by no movable parts to cause vibration, noise, wear, etc.; a simple structure and high reliability; and a long service life and easy maintenance. Such a thermoelectric conversion module has one or more, usually several tens or more, thermoelectric conversion elements. The individual thermoelectric conversion elements are electrically joined in series, and are thermally arranged in parallel.

The thermoelectric conversion module having such a configuration is used as a thermoelectric power generator using the Seebeck effect, extracting an electromotive force by depending on the difference between temperatures set at both ends of a thermoelectric conversion element, or as a thermoelectric temperature controller using the Peltier effect, cooling or heating one end of the thermoelectric conversion module by causing a difference in temperature by depending on the voltage applied across the thermoelectric conversion module.

Thermoelectric conversion materials can directly convert heat into electricity by the Seebeck effect or, conversely, can use electricity for heat (heating/cooling) by the Peltier effect. Thermoelectric conversion materials may be conventionally known materials for thermocouples for temperature measurement, for example, alloy or metal-alloy combinations such as Alumel/Chromel and platinum/platinum-rhodium.

However, in the case where it is necessary to generate a large electromotive force or high thermal output with a small-size one, a combination of a p-type semiconductor and an n-type semiconductor is used. Thermoelectric conversion modules using semiconductors have the advantages of being able to control temperature with precision, being able to perform local cooling, being silent, being subject to no CFC controls, having a long service life and high reliability, requiring no maintenance and the like, and have been used, for example, to control the temperature of laser diodes for optical communications.

On the other hand, in recent years, it has been required to substantially reduce CO₂ emission as a measure against global warming. It greatly contributes to energy savings and CO₂ reduction to make effective use of unused thermal energy in industrial, household, and transportation fields. Accordingly, thermal power generation modules capable of directly converting thermal energy into electric energy have been developed. For example, automobile engines utilize only a little less than 30% of energy on combustion as power, and discharge most of the rest of the energy together with exhaust gas.

If an efficient thermoelectric converter is developed in such a field, it can be expected to substantially save energy and reduce CO₂ emission. Thermoelectric converters for automobiles are required to not only be small and lightweight but also have strength, resistance to vibration, flexibility in shape, durability, a wide range of operating temperatures, freedom from maintenance, low impact on the environment, and the like. In particular, resistance to vibration and flexibility in shape are performance requirements different from those for other purposes.

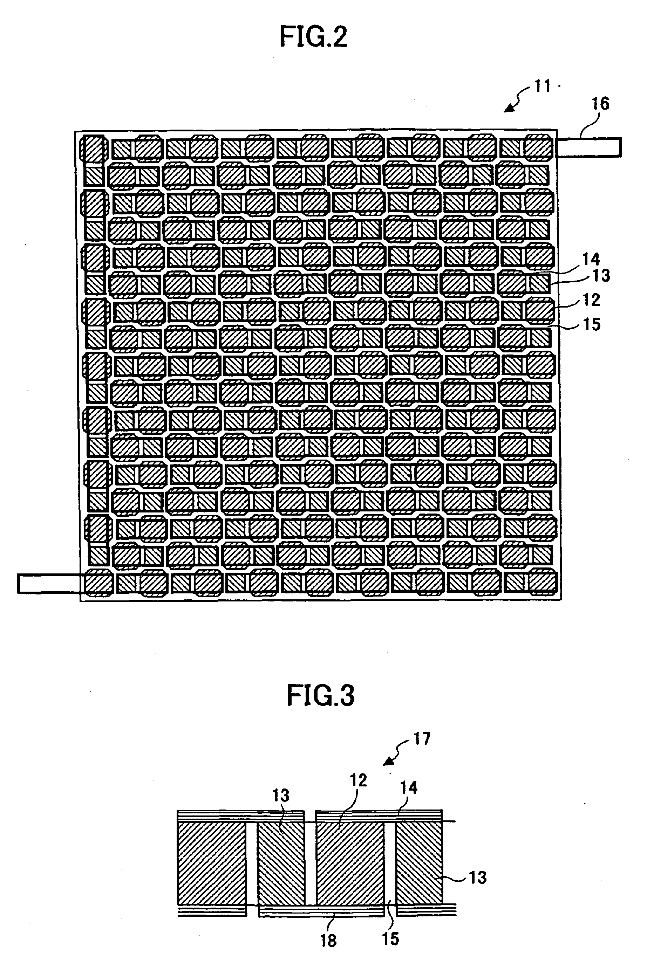

For example, FIG. 3 is a cross-sectional view showing two thermoelectric conversion elements being combined, in which a p-type semiconductor 12 and a n-type semiconductor 13 are coupled with an electrode 14 at an upper part and coupled with an electrode 18 at a lower part on the opposite side. For example, the electrode 14 and the electrode 18 do not join the same semiconductors, but join the p-type semiconductor 12 and the n-type semiconductor 13 in series from the p-type semiconductor 12 at an upper part at the left side of the drawing to the n-type semiconductor 13, then from the n-type semiconductor 13 to the p-type semiconductor 12 at a lower part, and then from the p-type semiconductor 12 to the n-type semiconductor 13 at an upper part so that they are successively joined in series and an electric current flows from a left upper side to a right lower side.

Accordingly, FIG. 2 is a plan view showing one hundred forty four thermoelectric conversion elements forming a thermoelectric conversion module 11. For example, in FIG. 2, the p-type semiconductor 12 and the n-type semiconductor 13 are coupled through an electrode to form a set of thermoelectric conversion elements while on the other side of the thermoelectric conversion elements (lower side, not shown), the p-type semiconductor 12 and the n-type semiconductor 13 of adjacent thermoelectric conversion elements are coupled through an electrode to form another set of thermoelectric conversion elements lower side, and the first n-type semiconductor and the second p-type semiconductor are coupled through the lower electrode to form another set of thermoelectric conversion elements.

That is, the p-type semiconductors 12 and the n-type semiconductors 13 are alternately coupled in series through electrodes. If a difference in temperature is caused between both sides (upper and lower sides in FIG. 3) of this thermoelectric conversion module 11, a predetermined electromotive force is generated across the thermoelectric conversion module based on the performance of each thermoelectric conversion element, the number of thermoelectric conversion elements coupled, and the difference in temperature between both ends of the thermoelectric conversion module 11.

Known semiconductors for thermoelectric conversion elements include Bi-Te system, Se-Te system, Cs-Bi-Te system, Pb-Te system, Pb-Se-Te system, Zn-Sb system, Co-Sb system, Ce-Fe-Co-Sb system, and Si-Ge system semiconductors, and the like. For example, a Bi-Te system thermoelectric material discovered by Goldsmid of the General Electric Company of the United States in 1954 is generally known as a thermoelectric material used in a low temperature range of normal temperature to approximately 200 °C.

In general, a lot of thermoelectric materials have a narrow range of application temperatures. Therefore, in the case of a Bi-Te system thermoelectric conversion material, a single-layer module is sufficient in a low temperature range less than 200 °C. On the other hand, studies for obtaining a highly efficient thermal power generation module by combining thermoelectric materials having different ranges of application temperatures into two to three layers have been made for a middle to high temperature range exceeding 200 °C.

Further, materials that perform with excellent characteristics in a middle-to-high temperature range have been developed. One of them is a Zn₄Sb₃ material, which is a p-type semiconductor thermoelectric material exhibiting high thermoelectric conversion performance in a middle temperature range of 200 to 400 °C. On the other hand, CoSb-based thermoelectric conversion materials can be p-type and n-type semiconductors that perform well in a middle-to-high temperature range of 300 to 700 °C.

However, many of these semiconductors contain hazardous metal, so that attention is required in both their manufacture and use. Recently, metal-oxide-based semiconductors have drawn attention as thermoelectric conversion element materials that are likely to clear environmental issues. For example, InO₂-SnO₂ system, (Ca, Bi)MnO₃ system, (Zn, Al)O system, Na(Co, Cu)O₄ system, NaCo₂O₄ system, and the like semiconductor thermoelectric element materials have been developed for practical use.

Generally, the thermoelectric conversion module is formed of several tens or more, sometimes several hundreds or more minute semiconductor devices, which are spaced apart from each other to form a skeleton structure.

However, as shown in FIG.2, it is accompanied by manufacturing complexity to arrange minute semiconductor devices in accordance with a desired arrangement pattern and form electrodes at both ends. Further, there is also a problem in that a completed module is mechanically weak. Several reports have been made of structures or manufacturing methods of a thermoelectric conversion module for solving these problems.

For example, there are a thermoelectric conversion module having p-type semiconductor devices and n-type semiconductor devices placed in a heat-resistant porous insulator (Patent Document 1) and a thermoelectric conversion module having p-type and n-type semiconductor devices housed in a molded substrate in which device housing holes are formed (Patent Document 2).

Thermoelectric conversion modules of such configurations, where p-type and n-type semiconductor devices are provided in an insulator with through holes formed therein without using a jig for providing the semiconductor devices, are characterized by improved assembling operability, better insulation between devices, and increased mechanical strength.

Further, there have been proposed thermoelectric conversion modules where the gap between semiconductor devices is filled with an insulating material. Specifically, there are a thermoelectric conversion module where one or more pairs of a p-type semiconductor device and an n-type semiconductor device provided in a desired arrangement are embedded in an insulating material (Patent Document 3) and a thermoelectric conversion module where multiple p-type semiconductor layers and n-type semiconductor layers are stacked and air gaps are formed therein except for p-n junction parts so as to be filled with a vitreous substance (Patent Document 4).

Further, there is a thermoelectric conversion module having semiconductor thermoelectric elements inserted into an insulating honeycomb structure through an alkali-metal-silicate-based inorganic adhesive agent or an insulating filler formed of sol-gel glass (Patent Document 5). Further, there is a highly reliable thermoelectric conversion module obtained by using a cordierite frame as a frame for a thermoelectric conversion module and controlling thermal conductivity by controlling the porosity of cordierite (Patent Document 6).

These thermoelectric conversion modules, which have the air gap between semiconductor devices filled with an insulating material, are characterized by increased mechanical strength and by improved oxidation resistance and corrosion resistance of semiconductor devices. Others known as frames of thermoelectric conversion modules include low-melting glass of B₂O₃-PbO molded and used as a frame as shown in Patent Document 7, calcium silicate mechanically processed and used as a frame as shown in Patent Document 8, and silica glass formed into a lattice shape as shown in Patent Document 9.

As conventional methods for manufacturing the thermoelectric conversion elements, a crystal growth method, a normal pressure powder sintering method by using cold press, and a hot pressurizing sintering method such as a hot press method are known. Generally, the thermoelectric conversion element manufactured by the crystal growth method has better characteristics than one manufactured by the powder sintering method by using the cold press or the hot press method.

However, in the crystal growth method, it takes a long time for manufacturing the thermoelectric conversion element. The thermoelectric conversion element manufactured by the crystal growth method has anisotropy of the crystal and cleavage. Therefore, the thermoelectric conversion element has low mechanical strength and low yield rate. Therefore, in this method, a manufacturing cost is high.

On the other hand, in the powder sintering method using the cold press, the row material powders are put in a mold and heating process is applied after press molding is implemented. In this method, the mechanical strength of the element is high and the yield rate is high. However, in order to implement the press, it is necessary to granulate the powder row material at a proper size again and eliminate minute powders. In addition, properties of the thermoelectric conversion element may be degraded due to impurities and it is necessary to remove these impurities. Accordingly, management of the row materials is critical.

In the hot press method, comparing to the powder sintering method by using the cold press, it is possible to implement sintering at one step. However, in this method, sintering is implemented by pressing the row materials directly and applying the heating simultaneously. Accordingly, in order to improve the sintering density, extremely high pressure and high temperature are required and a long sintering time cannot be shortened. In addition, purity management of the row material powder is necessary.

In recent years, a sintering method called a discharge plasma method is developed. In this discharge plasma sintering method as well as the hot press method, the raw material powder is sintered in the pressurized state. In this method, a normal external heating is not used. High voltages are applied to both ends of the row material and the discharge plasma is generated among the row material powders. By using the heat, the material powder is sintered. By this sintering method, the sintering temperature can be decreased and the sintering time can be reduced.

There are Patent Document 10 and Patent Document 11 which discuss manufacturing methods of the thermoelectric conversion element using a discharge plasma sintering method. In a technique discussed in Patent Document 10, a semiconductor thermoelectric conversion element and an electrode are simultaneously formed by a discharge plasma sintering method. Since the sintering can be done at a low temperature, it is possible to sinter while different kinds of materials are properly connected to each other. In a technique discussed in Patent Document 11, p-type and n-type oxide group semiconductor materials are arranged in a laminar manner and a thermoelectric conversion element, where the p-type and n-type oxide group semiconductor materials are connected to each other at a time by the discharge plasma sintering method is manufactured.

On the other hand, metal materials such as aluminum (A1) or copper (Cu) are used as electrode materials for the thermoelectric conversion module, and these electrode materials are connected to the thermoelectric conversion element by a spray method or a brazing method and the like. Especially, in a case where the electrode is formed by the spray method, it is necessary to insert the thermoelectric conversion element in a frame and then to perform the spray. This is because, if there is no frame, it is not possible to connect the p-type semiconductor element and the n-type semiconductor element to each other. In addition, electrical and thermal conduction between upper and lower surfaces of the thermoelectric conversion element are made to occur by a spray material adhering to a side surface of the thermoelectric conversion element, so that electric power generation characteristics are degraded.
[Patent Document 1] Japanese Laid-Open Patent Application No. 5-283753
[Patent Document 2] Japanese Laid-Open Patent Application No. 7-162039
[Patent Document 3] Japanese Laid-Open Patent Application No. 8-18109
[Patent Document 4] Japanese Laid-Open Patent Application No. 61-263176
[Patent Document 5] Japanese Laid-Open Patent Application No. 10-321921
[Patent Document 6] Japanese Laid-Open Patent Application No. 2005-129765
[Patent Document 7] Japanese Laid-Open Patent Application No. 8-153899
[Patent Document 8] Japanese Laid-Open Patent Application No. 11-340526
[Patent Document 9] Japanese Laid-Open Patent Application No. 2003-234516
[Patent Document 10] Japanese Laid-Open Patent Application No. 5-55640
[Patent Document 11] Japanese Laid-Open Patent Application No. 2002-118300
EP 1 030 379 A discloses a honeycomb-shaped body including thermoelectric elements.
US 6 127 619 A discloses a process for producing thermoelectric modules using thermoelectric pastes and a patternable insulator layer.
JP 2003 332644 A provides a method for making a thermoelectric module in which alternately arranged thermoelectric elements are collectively coupled with electrodes by means of a discharge plasma sintering device.
JP 2002 076451 A describes a method of manufacturing a thermoelectric module by inserting semiconductor powder into holes in a mold for sintering, sealing the powder with an upper punch and a lower punch together, placing heating elements on both sides of the jig, and pressing the heating elements from both sides, between which electric current is applied.
JP 2002 158379 A discloses a method of forming a thermoelectric module. The semiconductors are embedded within a plate-like aggregation between ceramic plates.
JP 9 008364 A describes a method of producing a thermoelectric conversion element by discharge plasma sintering.

Various kinds of thermoelectric converters have been reported as described above, and a thermoelectric converter having oxide-based semiconductors housed in a frame of a ceramic material is a possible thermoelectric converter for energy recovery usable in a range of normal temperature to approximately 1000 °C, resistant to vibration, having a certain level of strength, having little effect on the environment, and easily manufacturable as an in-vehicle thermoelectric converter.

There have been reports on individual element technologies such as semiconductors as thermoelectric conversion elements, a frame for placing multiple thermoelectric conversion elements, and electrodes to connect thermoelectric conversion elements. However, no thermoelectric converters have heat utilization efficiency that enables practical energy recovery while being balanced in performance wholly as an apparatus.

In order to improve thermoelectric converters in heat utilization efficiency, it is important to maintain a balance between the electromotive forces of p-type and n-type semiconductor materials, not to mention increasing their electromotive forces. However, no reports have been made of thermoelectric converters manufactured from such viewpoints.

In the manufacturing methods of the thermoelectric conversion elements described in Patent Document 10 and Patent Document 11, in order to manufacture a practical thermoelectric converter, each of the thermoelectric conversion elements should be manufactured and the designated numbers of them should be arranged.

### SUMMARY OF THE INVENTION

Accordingly, embodiments of the present invention may provide a novel and useful manufacturing method of a thermoelectric converter solving one or more of the problems discussed above.

More specifically, the embodiments of the present invention may provide an efficient manufacturing method of a thermoelectric converter with a large number of thermoelectric converters which can practically produce electric power.

One aspect of the present invention may be to provide a manufacturing method of a thermoelectric converter as defined in claim 1.

The non-metal inorganic material is a ceramic precursor; and in the semiconductor forming step, the honeycomb, the p-type semiconductor raw material, and the n-type semiconductor raw material are sintered.

The non-metal inorganic material is ceramic; and, in the semiconductor forming step, the p-type semiconductor and the n-type semiconductor are sintered.

After at least one of the p-type semiconductor raw material and the n-type semiconductor raw material is supplied in the piercing hole as powder or is supplied in the piercing hole as slurry or paste and dried, sintering may be implemented.

According to the above-mentioned embodiment of the present invention, it is possible to provide a manufacturing method proper for mass production of thermoelectric converters for producing an electric power.

### BRIEF DESCRIPTION OF THE DRAWINGS

Other objects, features and advantages of the present invention will become more apparent from the following detailed description when read in conjunction with the accompanying drawings, in which:
FIG. 1 is a schematic view of a semiconductor sintering apparatus according to an embodiment of the present invention;
FIG. 2 is a plan view of a thermoelectric converter; and
FIG. 3 is a schematic cross-sectional view of the thermoelectric conversion element.

### DETAILED DESCRIPTION OF THE PREFERRED EMBODIMENTS

First, a structure of a thermoelectric converter for electric power generation by a manufacturing method of the thermoelectric converter of the embodiment of the present invention is discussed.

In the thermoelectric converter for electric power generation, it is general practice to require a temperature difference of about 300 °C in the thermoelectric converter for electric power generation in order to obtain a high electromotive force. Because of this, while a low temperature side of the thermoelectric conversion element is set at a normal temperature, a high temperature side of the thermoelectric conversion element is set at a high temperature equal to or more than 300 °C.

Under these conditions, a material having heat resistance is required. It is preferable to use a honeycomb made of ceramic as a frame and arrange a p-type semiconductor or an n-type semiconductor in each piercing hole of this honeycomb, called a cell.

An end part of the p-type semiconductor and a neighboring end part of the n-type semiconductor are electrically connected to each other so as to be connected in series or parallel. Because of this, a high temperature end part of the semiconductor is connected to an end part of a semiconductor element different from one to which a low temperature end part of the semiconductor is connected.

In other words, as schematically shown in a cross-sectional view of FIG. 3 where plural thermoelectric conversion elements are connected to each other in series, the end part of the p-type semiconductors 12 and the end part of the n-type semiconductors 13 are sequentially connected to each other by the high temperature side electrodes 14 and the low temperature side electrodes 18.

FIG. 2 is a plan view of a thermoelectric converter according to the embodiment of the present invention. A thermoelectric converter 11 shown in FIG. 2 has cells. A p-type semiconductor 12 and an n-type semiconductor 13 are mutually arranged one in each of the cells formed between honeycomb partition walls 15 of the ceramic honeycomb. The p-type semiconductor 12 and the n-type semiconductor 13 are connected by the electrode 14 in the thermoelectric converter 11.

In the honeycomb, each cell has a desirable cross-sectional configuration and a cross-section. In the example shown in FIG. 2, a cell having an octagonal configuration similar to a foursquare configuration is formed for the p-type semiconductor element 12 and a cell 13 having a foursquare configuration is formed for the n-type semiconductor element.

In the thermoelectric converter 11 of the embodiment of the present invention, the honeycomb has 289 (17 × 17) cells. In this example, 144 (horizontally 8.5 × vertically 17 = 144.5) thermoelectric conversion elements are placed. It is general practice that several tens through several hundreds thermoelectric conversion elements formed by combining such p-type semiconductors 12 and n-type semiconductors 13 are arranged so that the thermoelectric converter for electric power generation is formed.

Next, the manufacturing method of the thermoelectric converter of the embodiment of the present invention is discussed on the assumption that this thermoelectric converter is used for electric power generation. First, a manufacturing method of the honeycomb having a larger number of cells is discussed.

The combination of the cross-sectional configurations of the cells corresponds to a combination of two kinds of the semiconductors, namely the p-type semiconductor and the n-type semiconductor and is proper for manufacturing the ceramic honeycomb.

It is preferable that the ratio of the honeycomb partition wall part between the cells other than a part effectively functioning, and the part where the semiconductor is arranged, be small. The honeycomb partition wall 15 cannot be extremely thin, considering the strength of the entire honeycomb and electrical insulating properties between the cells. In order to satisfy these conditions, it is preferable for the partition wall to have a thickness substantially constant and be as thin as possible, so long as the strength and the electrical insulating properties can be maintained.

If the thickness of the honeycomb partition wall 15 is not constant, as a whole, the part of the partition wall is large and the part of the cell parts that are piercing holes is small. In other words, the part where the semiconductor elements can be arranged is small so that the part that can be effectively used as the thermoelectric converter is small.

The honeycomb for the thermoelectric converter according to the present invention is made of an insulating non-metal inorganic material. The honeycomb may be manufactured by using glass, non-organic crystal material, an amorphous material, or the like. The honeycomb is made of ceramic. A honeycomb prior to finally forming the thermoelectric converter is a ceramic precursor discussed below. Ceramic materials may be any materials having insulation and heat resistance, such as oxide ceramic, silicon nitride, aluminum nitride, silicon carbide, and composite materials formed of these ceramic materials or containing these ceramic materials. Of these ceramic materials, oxide ceramic materials are particularly preferable.

Oxide ceramic materials are suitable materials in terms of heat resistance, insulation, strength, thermal conductivity, thermal expansibility, and the like. Thermal expansibility is preferably close to that of a below-described semiconductor material that is a thermoelectric element material rather than particularly high or low.

If the values of thermal conductivity and thermal expansibility of the honeycomb material are close to those of the thermoelectric element material, temperature is likely to be uniform in the internal cross section parallel to the surface of a thermoelectric conversion module when the materials are put in an environment of great temperature difference as the thermoelectric conversion module, so that it is possible to reduce distortion due to thermal expansion. Preferable oxide ceramic materials include alumina, silica, magnesia, mullite, cordierite, aluminum titanate, titania, ceria, and the like. Of these, alumina and cordierite are particularly suitable honeycomb materials in terms of balance of strength, insulating properties, and heat resistance.

The above-mentioned ceramic honeycomb structure may be manufactured by a conventionally known method. For example, the grain size of a raw material powder may be adjusted so that the powder becomes slurry and forming (molding), drying, degreasing, and the like may be performed. As a result of this, a ceramic precursor having a ceramic structure is manufactured and may be sintered.

At the time of forming (molding), it is convenient that the honeycomb structural body be made by extrusion molding, cut at a proper length, dried, and degreased. Alternatively, the honeycomb structural body may be manufactured by pressurized forming (molding) as a powder and then performing sintering. In addition, the honeycomb structural body may be formed and sintered in a single step by hot pressing.

The manufactured ceramic honeycomb may have a size corresponding to the size of an individual thermoelectric converter before sintering is performed. Generally, the thermoelectric converter for electric power generation has a plate-shaped configuration having sides of several mm through several tens square cm and thickness of 0.5 mm through several mm. Accordingly, the honeycomb may have a integral multiple size corresponding to a size of a designated thermoelectric converter and sintered, and may be cut to be the size of the thermoelectric converter after sintering is performed or the semiconductor is formed in the cell.

A manufacturing method of the ceramic honeycomb of the thermoelectric converter of the embodiment of the present invention is discussed by using an example where cordierite is used.

A raw material powder of cordierite is composed of oxides whose main elements are aluminum (A1), silicon (Si) and magnesium (Mg). When aluminum (A1), silicon (Si) and magnesium (Mg) are converted into oxides and the sum of them are defined as 100%, 10 through 30% of Al₂O₂, 40 through 60% of SiO₂, and 10 through 30% of MgO are contained. In addition, impurities such as 0 through 0.05% of CaO, 0 through 0.05% of Na₂O, 0 through 0.05% of K₂O, 0 through 1% of TiO₂, 0 through 1% of Fe₂O₂, 0 through 1% of PbO, and 0 through 0.2% of P₂O₅ may be contained. It is preferable that contained percentage of unavoidable elements such as CaO, Na₂O, K₂O, TiO₂, Fe₂O₂, PbO, and P₂O₅ be equal to or less than 2.5%. While most of the honeycomb after sintering is performed becomes cordierite, the honeycomb may contain mullite, spinel, or the like.

The above-mentioned material together with a forming assistant is supplied into a medium such as water or alcohol and mixed and crushed sufficiently by a ball-mill, or the like. After that, the raw material is made to be slurry so that a green pillar state of the honeycomb structural body is manufactured by extrusion molding. This honeycomb structural body may have the same size as that of the thermoelectric converter. However, it is normal practice that the cross section and length of the honeycomb structure be more than those of the thermoelectric converter and it is convenient to use it while the honeycomb structural body is cut during a manufacturing step of the thermoelectric converter.

In addition, it is normal practice that the cross-sectional configuration of each cell of the honeycomb structural body has a four-square configuration, hexagonal configuration, circular configuration, a rectangular configuration close to the four-square configuration or octagonal configuration, or the like. Furthermore, the ratio of cross sections of the p-type semiconductor and the n-type semiconductor is determined by corresponding to the cross sections of each semiconductor expected from properties of the p-type semiconductor and the n-type semiconductor of a desirable thermoelectric conversion module. For example, the ratio of cross sections of the p-type semiconductor and the n-type semiconductor may be 1:3 through 3:1.

This honeycomb structural body is dried and degreased. The degreased honeycomb structural body may be cut at a thickness corresponding to the thermoelectric converter after firing is done, so that a thin plate honeycomb can be formed. Firing is completed at the temperature of 1200 through 1450 °C for several through several tens hours. The cordierite honeycomb may be cut so as to be a thin plate honeycomb. Cutting may be done after the semiconductor material is inserted or the semiconductor material is fired.

Next, a semiconductor raw material supplying step for supplying a semiconductor material into the honeycomb and a semiconductor forming step for forming the p-type semiconductor and the n-type semiconductor in the cells of the honeycomb are discussed.

A designated semiconductor material is inserted into each cell of the plate-shaped honeycomb manufactured by the above-discussed steps. The semiconductor material may have any configuration such as powder, slurry, or paste. In the case of the slurry or the paste, re-drying is done so that the solvent is removed. The plate-shaped honeycomb where the semiconductor material is inserted is fired so that the cordierite honeycomb where the semiconductor is inserted into each cell is obtained.

Firing is done under the condition of the temperature being 900 through 1400 °C corresponding to the sintering temperature of the semiconductor as well as the normal cordierite firing condition. Sintering of the semiconductor while pressure is applied is advantageous because it is possible to easily form a minute semiconductor having low electric resistance, good thermoelectric conversion properties, and the like.

A surface of the completed honeycomb is polished so that the surface of the fired semiconductor and the surface of the honeycomb are smoothed. In a case where the size of honeycomb is more than that of the desirable thermoelectric converter, cutting is performed so that the honeycomb for the thermoelectric converter can be taken out. For example, in a case where the longitudinal and horizontal lengths of the honeycomb are three times those of the thermoelectric converter, the longitudinal and horizontal lengths of the honeycomb are cut for every one third so that nine honeycombs for thermoelectric converter are manufactured. In a case where the thickness of the honeycomb is ten times that of the honeycomb for the thermoelectric converter, the honeycomb is cut to ten pieces so that ten honeycombs for thermoelectric converters are manufactured.

As a modified example of forming the semiconductors, the semiconductor material may be inserted in a green state honeycomb which is not sintered yet and then the semiconductor material may be sintered simultaneously with the honeycomb.

Semiconductor materials for thermoelectric conversion elements in the manufacturing method of the thermoelectric converter of the embodiment of the present invention may be any materials as long as they have a thermoelectric conversion function after sintering is done. The thermoelectric conversion function of a semiconductor material after the semiconductor raw material is sintered is as follows.

Since a p-type semiconductor and an n-type semiconductor generate electromotive forces of opposite polarities with the same temperature difference, by connecting the end of the p-type semiconductor and the end of the n-type semiconductor through an electrode on one side of the thermoelectric conversion module, an electromotive force that is the sum of the electromotive force of the p-type semiconductor and the electromotive force of the n-type semiconductor is obtained between the end of the p-type semiconductor and the end of the n-type semiconductor on the opposite side.

Usually, these terminals on the opposite side are coupled to the terminals of corresponding adjacent thermoelectric conversion elements so as to increase the electromotive force. At this point, series coupling and parallel coupling are possible as methods of coupling adjacent thermoelectric elements. Thinking about only a theoretical electromotive force, the same electromotive force is obtained by either method, and the difference lies between collecting in high-voltage, small-current power and collecting in low-voltage, large-current power.

Practically, however, internal resistance is generated in the semiconductor material when a current flows therethrough because the semiconductor material is not a conductor. In order to reduce its effect, it is preferable to reduce current flowing inside the semiconductor. For this purpose, it is preferable that the individual thermoelectric conversion elements in the thermoelectric conversion module be coupled in series. As a result of this, a high-voltage and small-current electromotive force is generated.

Specific semiconductor materials include Bi/Te system, Se/Te system, Cs/Bi/Te system, Pb/Te system, Pb/Se/Te system, Zn/Sb system, Co/Sb system, Ce/Fe/Co/Sb system, Si/Ge system materials, and the like as combinations of p-type and n-type semiconductors. More preferable semiconductor materials include InO₂-SnO₂ system, (Ca, Bi) MnO₃ system, (Zn, Al)O system, Na(Co, Cu) O₄ system, NaCo₂O₄ system and the like materials. Particularly preferable combinations of p-type and n-type semiconductors include a combination of NaCoO₂ and ZnO, a combination of NaCoO₂ and (Ca_{0.9}Bi_{0.1}) MnO₃, a combination of Ca₃CO₄O₉ and ZnO, a combination of Ca₃Co₄O₉ and (Ca_{0.9}Bi_{0.1})MnO₃ and the like.

Here, semiconductor materials are shown as Bi-Te system, ZnO, etc., which are all p-type or n-type semiconductors formed by doping with other elements, and are not limited to pure metals or metal compounds. For example, ZnO may be an n-type semiconductor formed by doping with Al.

Next, an electrode connecting step for connecting the p-type semiconductor and the n-type semiconductor in the honeycomb by an electrode made of copper (Cu) or the like, for example, is discussed with reference to a cross-sectional view of the thermoelectric conversion element shown in FIG. 3.

The honeycomb where the semiconductor is formed in the cell whose configuration is adjusted as the thermoelectric converter is connected to the electrode. In an upper part in FIG. 3 that is a high temperature side connection of the thermoelectric conversion element 17, the p-type semiconductor 12 and the n-type semiconductor 13 are connected to each other by a high temperature side electrode 14 made of copper (Cu).

The high temperature side electrode 14, the p-type semiconductor 12 and the n-type semiconductor 13 are adhered to each other by a conductive adhesive member. This adhesive member improves the adhesive properties between the high temperature side electrode 14, the p-type semiconductor 12 and the n-type semiconductor 13 and prevents the diffusion of atoms into each other. This is because if the atoms move in or from the semiconductor, the thermoelectric conversion properties may be degraded. It is preferable to select a material such as platinum (Pt), hafnium (Hf) or silver (Ag) having properties where diffusion to/from the semiconductor is small as a material of the adhesive member. Connection to the electrode may be made by any way such as spraying, transferring, coating and adhering. It is preferable that the electrode surface of the thermoelectric conversion element is covered with insulation. As a result of this, generated electric power is prevented from being leaked to the outside and the semiconductor material and the electrode material are protected at the high temperature electrode side from oxidation degradation due to high temperature atmosphere or the like.

In the connection of the lower part of the thermoelectric conversion element that is a low temperature side connection of the thermoelectric conversion element, the p-type semiconductor 12 and the n-type semiconductor 13 are connected to each other by a low temperature side electrode 18 made of copper (Cu).

The low temperature side electrode 18 as well as the high temperature side electrode 14 and, the p-type semiconductor 12 and the n-type semiconductor 13 are adhered to each other by a conductive adhesive member. However, since the temperature in use is low, there is almost no case diffusion where the atoms move from the electrode to the semiconductor or from the semiconductor to the electrode.

A manufacturing method of the thermoelectric converter using a discharge plasma sintering method in a semiconductor forming step is discussed. Sintering time for forming the semiconductor in this manufacturing method of the thermoelectric converter using a discharge plasma sintering method is extremely shorter than that in the manufacturing method of the above-discussed thermoelectric converter so that sintering temperature can be made low.

In the discharge plasma sintering method, oxide semiconductor material powder having conductivity is directly sintered at low temperature, for a short period of time, and in a pressurized vacuum state by discharge plasma and a single step. Normally, sintering time is several minutes.

A material used for pressureless sintering , hot press sintering, or the like is used as a starting material. A material powder obtained after reaction and mixture by a ball mill, for example, a conductive metal oxide chemical compound including a transition metal and an alkali metal having the p-type semiconductor properties such as NaCo₂O₄, Na, Li solid solution tetragon or a wurtzite structure zinc oxide having the n-type semiconductor properties where a small amount of Al is added, is used.

It is preferable that the grain size of the powder be a minute 0.1 µm through 100 µm. These starting powder raw materials are supplied in the cell of the honeycomb and provided in the discharge plasma sintering apparatus. A vacuum state is maintained so that the discharge plasma is generated. A direct current pulse is applied while pressurizing from both sides of the cell so that sintering is performed by using heat generated between the raw material powder particles.

The raw material powder particle supplied in the cell of the honeycomb may be supplied as a powder. If it is difficult to supply the powder due to minute particles, the raw material powder may be made into a slurry or paste; supplied in the cell and dried, and then sintered. In this discharge plasma sintering method, it is preferable to control the pressurizing pressure to be 10 MPa through 47 MPa, time to be 1 through 5 minutes, applied electrical current voltage to be 1 through 3 kA and 1 through 10 V and temperature to be 600 °C through 900 °C.

In the discharge plasma sintering, the semiconductor raw material supplied in the cell may be sintered cell by cell. However, it is advantageous from the view point of reduction of sintering time that the semiconductor raw materials be supplied in all cells of a single honeycomb and the semiconductor raw materials in the cell be simultaneously sintered by the discharge plasma. If the sintering conditions of the p-type semiconductor raw material and the n-type semiconductor raw material are extremely different, the p-type semiconductor raw material and the n-type semiconductor raw material may be independently sintered. In this case, it is preferable to sinter the p-type semiconductor raw material and the n-type semiconductor raw material each in a lump.

In addition, ceramic honeycomb may not be used as the honeycomb where the semiconductor raw material is supplied. As the ceramic precursor honeycomb before sintering is done, the entirety of the honeycomb filled by the semiconductor raw material may be pressurized for sintering. In the discharge plasma sintering, it is possible to sinter at a relatively low temperature for a short period of time. Therefore, moving or diffusion of atoms between different kinds of materials is minimal. Hence, it is possible to easily perform the ceramic honeycomb manufacturing step and the semiconductor manufacturing step simultaneously.

In addition, a raw material of the adhesive member for adhering the semiconductor element and the electrode to each other in the connecting step for connecting the semiconductor and the electrode to each other is made fine and the fine material with the semiconductor raw material can be simultaneously sintered by the discharge plasma. It is preferable to select, as a raw material of the adhesive member, a material such as platinum (Pt), hafnium (Hf) or silver (Ag) having properties where diffusion to/from the semiconductor is small.

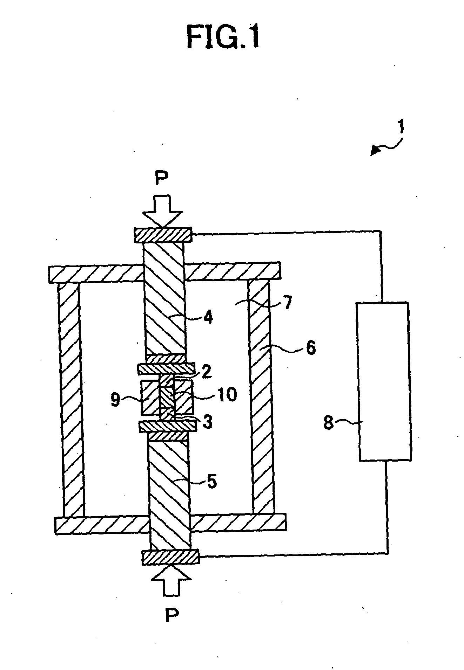

A detailed example of the discharge plasma sintering is discussed with reference to FIG. 1. FIG. 1 shows a discharge plasma sintering apparatus configured to sinter the semiconductor material supplied in a single cell of the ceramic honeycomb.

More specifically, numerical reference 1 denotes a discharge plasma sintering apparatus, and numerical reference 10 denotes a raw material powder of the semiconductor material supplied in the cell of the ceramic honeycomb 9. In a sintering space 7 within a sintering vessel 6, the semiconductor material 10 is provided in a vacuum state where plasma is generated in the raw material powders. The semiconductor material 10 is pressurized in the vacuum state from upper and lower parts by pressurizing members 4 and 5 and the raw material powders are supplied in a dense manner. Electrodes 2 and 3 are provided at head ends of the pressurizing members 4 and 5 so that a high voltage is applied to the semiconductor material 10.

The pulse state high voltage is applied to the semiconductor material 10 under the vacuum atmosphere and pressurizing atmosphere. As a result of this, the discharge plasma is generated in the minute powder particles of the semiconductor materials 10. At this time, high temperature is formed in the vicinity of the plasma so that the minute powder particles are sintered with each other. Since only an adjacent part of the minute powder particles is influenced by the heat of the plasma, it is possible to perform sintering without influencing all the powder. In addition, because of this, it is possible to perform sintering without heating all the semiconductor material 10 to a high temperature.

The advantages of the discharge plasma sintering are as follows.
(1) It is possible to perform sintering for a short period of time;
(2) It is possible to perform sintering at a relatively low temperature;
(3) It is possible to obtain the semiconductor having high conductivity so that internal resistance as the thermoelectric conversion element can be reduced;
(4) Since sintering is performed under the pressurized situation, it is possible to form the dense sintered body;
(5) It is possible to perform carrier density control by atmosphere control;
(6) Since particle growth does not occur and particle interface is increased, thermal conductivity of polycrystal is decreased; and
(7) It is possible to sinter different kinds of materials simultaneously.

It is general practice that the thermoelectric converter requires a large number of the thermoelectric conversion elements for generating a large electromotive force. On the other hand, in order to make the thermoelectric conversion element efficiently generate the electromotive force, it is necessary to make the length in a temperature difference direction of the thermoelectric conversion element, namely the thickness of the thermoelectric converter, as small as possible. In order to satisfy both requirements, a thin plate-shaped thermoelectric converter having a large area is required.

However, in a case of such a configuration, deformation of the thermoelectric converter due to thermal expansion is large and breakage of the thermoelectric converter may be easily caused. In addition, in the case of a thin thermoelectric converter having a large area, the thermoelectric converter may be easily damaged due to external stress such as bending stress. Because of this, in the thermoelectric converter of the embodiment of the present invention, it is preferable to manufacture the thermoelectric converter for generating a desirable electromotive force by connecting plural thermoelectric conversion modules having a size equal to or less than the predetermined size.

The thermoelectric conversion module is a unit for thermoelectric conversion. Each of the thermoelectric conversion modules may have a predetermined size corresponding to use of the module. If the thermoelectric conversion module is less than or equal to a predetermined size, thermal distortion due to the difference between the thermal expansion of both sides of the thermoelectric conversion module is small, so that the thermoelectric conversion module is less likely to break even with thermal impact, mechanical impact, or vibrations. Further, strength is sufficient even with a ceramic, which is a brittle material, used as the frame. Further, a ceramic, which has heat resistance and electrical insulation, is convenient as a frame.

With respect to a specific size of this thermoelectric conversion module, the maximum length in a cross section perpendicular to a through hole of the honeycomb is preferably less than or equal to 100 mm, and more preferably less than or equal to 50 mm in particular.

The maximum length of the cross section is the length of a side in the case of a square or a rectangle, the distance between opposing sides in the case of a hexagon or an octagon, or a diameter in the case of a circular shape. Usually, the shape of the cross section perpendicular to the through hole of the honeycomb is preferably a square, a rectangle, or an octagon approximate to a square in terms of the strength and the placement efficiency of the thermoelectric conversion module.

The lower limit of the maximum length of the above-described cross section is not limited in particular, but is preferably more than or equal to 5 mm, more preferably more than or equal to 10 mm, and still more preferably more than or equal to 20 mm considering the size of a semiconductor device and the number of cells of the ceramic honeycomb.

In general, a ceramic honeycomb structure of 0.7 to 2.0 mm in thickness is more likely to sustain brittle fracture in response to a bending stress if the maximum length of the above-described cross section is more than or equal to 50 mm, in particular 100 mm. Further, the weight increases in proportion to the size, so that a stress is likely to be applied in response to impact so as to increase the risk of breakage.

If the width of each cell is determined to be 0.8 mm and the partition wall between cells is determined to be 0.2 mm in thickness based on the above-described honeycomb 10 cm square in size, the number of cells formable is 10,000 pcs (100 x 100), and the number of cells is preferably smaller than this. Usually, it is preferable that the number of cells be 100 to 2000 pcs.

As a honeycomb where the cell for the p-type semiconductor and the cell for the n-type semiconductor have the same cross-sections, the cell structures of four-square and hexagon are known. These honeycombs are divided by the partition walls having the same thickness of the partition wall and arranged regularly. As a honeycomb where the cell for the p-type semiconductor and the cell for the n-type semiconductor have different cross sections, for example, a combination of cells having cross-section of four-square configuration and hexagonal configuration formed by removing four corners from a larger four-square configuration as shown in FIG. 2 is preferable. In addition, the short side of the rectangular configuration may be a combination of the rectangle and a four-square whose side is the same as the side of the rectangle. According to such a honeycomb structure, it is possible to optionally change the area ratio of two kinds of cells and a partition wall between cells may be constant and a necessary minimum thickness. Hence, it is possible to avoid useless parts of the partition wall not contributing the power generation. Therefore, such a honeycomb structure is suitable for the combination of detailed two kinds of cells.

In a thermoelectric converter formed by connecting multiple thermoelectric conversion modules, it is preferable that the thermoelectric conversion modules be connected to each other in a movable manner. If the thermoelectric conversion modules are coupled so as to be movable relative to each other, each thermoelectric conversion module moves relatively to relieve a stress even if a mechanical stress or a stress due to the effect of heat is applied to the thermoelectric converter. Alternatively, a coupling member that couples the thermoelectric conversion modules in a movable manner absorbs the stress, so that a flow stress is less likely applicable to the thermoelectric conversion modules.

The thermoelectric converter having thermoelectric conversion modules connected to each other in a movable manner is also effective in handling and installation in a desired part. For example, it is possible to place the thermoelectric converter while deforming it in accordance with the shape of an installation location. In the case of installing the thermoelectric converter in the exhaust pipe of an automobile engine, the thermoelectric converter may be formed to have a cylindrical shape.

The thermoelectric conversion modules may be connected to each other in a movable manner by, for example, arranging the thermoelectric conversion modules on a flexible substrate. The substrate and the thermoelectric conversion modules may be connected by any method, for example, bolting, fixing with hooks projecting from the substrate, or bonding with an adhesive agent. The materials of the substrate and a joining jig and the joining method are selected in view of the environment in which the thermoelectric conversion modules are to be used.

For example, in the case of placing the substrate on the higher temperature side of the thermoelectric conversion modules, it is preferable to select a metal material that resists the service temperature of the substrate. In the case of placing the substrate on the lower temperature side of the thermoelectric conversion modules, it is also possible to select a plastic or rubber material that resists the service temperature of the substrate. Further, the substrate may not be used as a connection method, and the thermoelectric conversion modules may be connected with flexible tapes or string-like connecting members. Alternatively, the thermoelectric conversion modules may be coupled with a flexible adhesive agent. Further, it is also possible to use leads or connecting terminals for electrically connecting the thermoelectric conversion modules as flexible connection members.

The thermoelectric converter according to the embodiment of the present invention can be suitably used as an in-vehicle one that utilizes automobile waste heat. The thermoelectric converter according to the embodiment of the present invention may be placed around the exhaust pipe of an automobile to generate power.

For example, in the in-vehicle thermoelectric converter, the thermoelectric converter is placed on the side facing an exhaust pipe, while a cooling unit of, for example, a cooling water circulation or air cooling type is provided on the lower temperature side.

The thermoelectric converter has platelike thermoelectric conversion modules of approximately 30 mm square and 1 mm in thickness fixed with a thin metal plate. Since the metal plate is flexible, the metal plate absorbs vibrations of the automobile and impact so as to prevent a great mechanical stress from being applied to the thermoelectric conversion modules. Further, since the thermoelectric conversion modules have a plate shape of approximately 30 mm square, thermal stress is prevented from becoming high as well. Since this thermoelectric module is formed in a body with a small size ceramic honeycomb, this module has high strength, high resistance against vibration, high durability, and the like, and therefore is suitable for in-vehicle use.

The manufacturing method of the thermoelectric converter according to the embodiment of the present invention, which can extract high power from heat sources of relatively low temperatures through high temperatures, approximately 1000 °C, can be used as a power generator. In particular, the thermoelectric converter of the present invention has high heat utilization efficiency, and can effectively extract heat from automobile exhaust gas to generate electrical power as an in-vehicle power generator, so as to be usable as a power source for motive power or auxiliary devices.

## Claims

1. A manufacturing method of a thermoelectric converter (11) **characterized by** comprising:
a raw material supplying step of mutually supplying a p-type semiconductor raw material (10) and an n-type semiconductor raw material (10) into a piercing hole of a honeycomb (9) made of an insulating non-metal inorganic material;
a semiconductor forming step of simultaneously sintering the p-type semiconductor raw material (10) and the n-type semiconductor raw material (10) supplied in the honeycomb (9), wherein, while the p-type semiconductor raw material and the n-type semiconductor raw material supplied in the piercing hole of the honeycomb are pressurized (P), a voltage (8) is applied so that discharge plasma is generates for the sintering, and forming a p-type semiconductor (12) and an n-type semiconductor (13) in the piercing hole of the honeycomb (15); and
an electrode (14, 18) connecting step of connecting the p-type semiconductor (12) and an n-type semiconductor (13) formed in the piercing hole of the honeycomb to each other by an electrode;
wherein
the non-metal inorganic material is a ceramic precursor; and
in the semiconductor forming step, the honeycomb, the p-type semiconductor raw material, and the n-type semiconductor raw material are sintered.

2. The manufacturing method of the thermoelectric converter as claimed in claim 1, **characterized in that**
after at least one of the p-type semiconductor raw material and the n-type semiconductor raw material is supplied in the piercing hole as powder or is supplied in the piercing hole as slurry or paste and dried, sintering is implemented.

## Patentansprüche

1. Herstellungsverfahren für einen thermoelektrischen Umwandler (11), **gekennzeichnet** indem es aufweist:
einen Rohmaterialzuführschritt des gegenseitigen Zuführens eines p-Typ-Halbleiterrohmaterials (10) und eines n-Typ-Halbleiterrohmaterials (10) in ein durchdringendes Loch einer Wabe (9), die aus einem isolierenden, nichtmetallischen anorganischen Material hergestellt ist;
einen Halbleiterausbildungsschritt des gleichzeitigen Versinterns des p-Typ-Halbleiterrohmaterials (10) und des n-Typ-Halbleiterrohmaterials (10), die in die Wabe (9) zugeführt wurden, wobei, während das p-Typ-Halbleiterrohmaterial und das n-Typ-Halbleiterrohmaterial, die in das durchdringende Loch der Wabe zugeführt wurden, mit Druck (P) beaufschlagt werden, eine Spannung (8) so angelegt wird, dass ein Entladungsplasma für das Versintern erzeugt wird, und des Ausbildens eines p-Typ-Halbleiters (12) und eines n-Typ-Halbleiters (13) in dem durchdringenden Loch der Wabe (15); und
einen Elektrode-(14, 18)-Verbindungsschritt des Verbindens des p-Typ-Halbleiters (12) und eines n-Typ-Halbleiters (13), die in dem durchdringenden Loch der Wabe ausgebildet wurden, miteinander durch eine Elektrode,
wobei
das nichtmetallische anorganische Material ein Ausgangsstoff für Keramik ist; und
beim Halbleiterausbildungsschritt die Wabe das p-Typ-Halbleiterrohmaterial und das n-Typ-Halbleiterrohmaterial versintert werden.

2. Herstellungsverfahren für einen thermoelektrischen Wandler nach Anspruch 1, **dadurch gekennzeichnet, dass**
nachdem das p-Typ-Halbleiterrohmaterial und/oder das n-Typ-Halbleiterrohmaterial in das durchdringende Loch als ein Pulver zugeführt wurden oder in das durchdringende Loch als eine Suspension oder als eine Paste zugeführt wurden und getrocknet wurden, das Versintern durchgeführt wird.

## Revendications

1. Procédé de fabrication d'un convertisseur thermoélectrique (11) **caractérisé en ce qu'**il comprend :
une étape de fourniture de matière première pour fournir mutuellement une matière première semi-conductrice de type p (10) et une matière première semi-conductrice de type n (10) dans un trou de perçage d'un nid d'abeilles (9) fait d'une matière inorganique non métallique isolante ;
une étape de formation de semi-conducteur pour fritter simultanément la matière première semi-conductrice de type p (10) et la matière première semi-conductrice de type n (10) fournies dans le nid d'abeilles (9), dans lequel, tandis que la matière première semi-conductrice de type p et la matière première semi-conductrice de type n fournies dans le trou de perçage du nid d'abeilles sont mises sous pression (P), une tension (8) est appliquée de sorte qu'un plasma de décharge est généré pour le frittage, et de formation d'un semi-conducteur de type p (12) et d'un semi-conducteur de type n (13) dans le trou de perçage du nid d'abeilles (15) ; et
une étape de connexion d'électrode (14, 18) pour connecter le semi-conducteur de type p (12) et un semi-conducteur de type n (13) formé dans le trou de perçage du nid d'abeilles l'un à l'autre par une électrode ;
dans lequel
la matière inorganique non métallique est un précurseur céramique ; et
dans l'étape de formation de semi-conducteur, le nid d'abeilles, la matière première semi-conductrice de type p et la matière première semi-conductrice de type n sont frittés.

2. Procédé de fabrication du convertisseur thermoélectrique selon la revendication 1, **caractérisé en ce que**
après qu'au moins une de la matière première semi-conductrice de type p et de la matière première semi-conductrice de type n est fournie dans le trou de perçage en tant que poudre ou est fournie dans le trou de perçage en tant que boue ou pâte et est séchée, un frittage est mis en oeuvre.
